Europäisches Patentamt

European Patent Office

Office européen des brevets

(19)

(11) **EP 0 743 748 A1**

(12) **EUROPEAN PATENT APPLICATION**

(43) Date of publication:
20.11.1996 Bulletin 1996/47

(51) Int. Cl.⁶: $H03H\ 9/42$, $G10K\ 11/36$

(21) Application number: 95107356.8

(22) Date of filing: 15.05.1995

(84) Designated Contracting States:
DE FR GB IT NL

(71) Applicant: CANON KABUSHIKI KAISHA
Tokyo (JP)

(72) Inventors:
• Eguchi, Tadashi,
c/o Canon K.K.
Ohta-ku, Tokyo 146 (JP)
• Torisawa, Akira,
c/o Canon K.K.
Ohta-ku, Tokyo 146 (JP)
• Mochizuki, Norihiro,
c/o Canon K.K.
Ohta-ku, Tokyo 146 (JP)

• Egara, Koichi,
c/o Canon K.K.
Ohta-ku, Tokyo 146 (JP)
• Koyama, Akihiro,
c/o Canon K.K.
Ohta-ku, Tokyo 146 (JP)
• Hachisu, Takahiro,
c/o Canon K.K.
Ohta-ku, Tokyo 146 (JP)

(74) Representative: Tiedtke, Harro, Dipl.-Ing.
Patentanwaltsbüro
Tiedtke-Bühling-Kinne & Partner
Bavariaring 4
80336 München (DE)

(54) **Surface acoustic wave apparatus and communication system using it**

(57)     A surface acoustic wave apparatus has a substrate having piezoelectricity (11), an input transducer (13) formed on a principal surface of the substrate, for generating a surface acoustic wave, a waveguide (14) for guiding the surface acoustic wave generated by the input transducer (13), and a device (13) for converging and inputting the surface acoustic wave generated by the input transducer (12) into the waveguide. In the apparatus, a distance (R+L) between the device for converging (13) and inputting and an end portion of the waveguide (14) as opposed to the input transducer (13) is in the range of approximately 10λ and 100λ both inclusive where λ is a wavelength of the surface acoustic wave generated by the input transducer. A communication system has a transmitter (40) for transmitting a spread-spectrum-modulated signal, and a receiver (41) having the surface acoustic wave apparatus for obtaining a convolution signal between a spread-spectrum-modulated signal input thereinto and a reference signal.

FIG. 1

( R+L = 10λ—110λ )
R +L

13

14      15      12

m ( m = 1λ—4λ )

11

## Description

### BACKGROUND OF THE INVENTION

#### Field of the Invention

The present invention relates to a surface acoustic wave apparatus, and more particularly, to a surface acoustic wave apparatus having an input transducer for generating a surface acoustic wave, and a waveguide for guiding the surface acoustic wave generated. The invention also concerns a communication system using the surface acoustic wave apparatus.

#### Related Background Art

One of the surface acoustic wave apparatus is a surface acoustic wave (SAW) convolver.

The SAW convolver is a signal processing device for performing a convolution operation of two signals, which is recently drawing attention as a key device in spread spectrum communication system.

Since the SAW convolver is a device utilizing the nonlinear effect, it generally has a low efficiency. As methods for improving the efficiency there are thus some methods proposed in such an arrangement that means for compressing the beam width of surface acoustic wave is provided to make the surface acoustic wave in enhanced energy density propagate into a narrow output electrode, thereby improving the efficiency.

One of them is a method of using an arcuate input comb electrode (IDT; Interdigital Transducer) by which the surface acoustic wave is focused to enter the output electrode. The SAW convolver using such arcuate IDT is known as described in J. B. Green and G. S. Kino, "SAW Convolvers Using Focused Interdigital Transducers," IEEE Trans. on Sonics and Ultrasonics, Vol. 30, No. 1, 43-50 (1983) (reference 1), and in USP No. 4,649,509, Mar. 10, 1987 (reference 2).

In the above reference 1, velocity anisotropy of a substrate forming the device is approximated, a focused position of the surface acoustic wave generated by the arcuate IDT is derived by calculation, and the end of the output electrode is located at the focused position calculated.

In the above reference 2, the IDT is formed so as to approximately match to a bending shape of wavefront when the surface acoustic wave propagating in the output electrode is radiated from the end of output electrode and is propagating. Further, the IDT has frequency dispersion, and thus, electrode digits composing the IDT are arranged not at equal intervals but at different intervals depending upon respective wavelength regions due to dispersion.

Further, Japanese Patent Application No. 5-65971 (reference 3) employs the IDT curved in a shape matching to the velocity anisotropy of a piezoelectric substrate, thereby making the surface acoustic wave generated by the IDT coupling to the guided modes of the output electrode with good efficiency.

The device as described in the above reference 1, however, has a problem that the distance from the input electrode to the output electrode is long, about 160$\lambda$ (where $\lambda$ is the wavelength of a surface acoustic wave propagating in the Z-axis direction in a Y-cut Z-propagate lithium niobate substrate (hereinafter referred to as YZ-lithium niobate substrate); where 160$\lambda$ is 3.43 mm at frequency of 160 MHz), resulting in increasing the device size.

Incidentally, many SAW devices utilize a piezoelectric substrate (having velocity anisotropy) in which the velocity differs depending upon the propagating direction of surface acoustic wave (SAW). In YZ-lithium niobate, within a range of from the Z axis to about 22°, the propagation velocity of SAW is highest in the Z-axis direction and the propagation velocity becomes slower as an angle to the Z axis becomes greater. Since the velocity characteristic of YZ-lithium niobate is symmetric with respect to the Z axis, guided modes of odd orders are not normally generated; but, if the direction of the output electrode of convolver deviates from the Z axis of the lithium niobate substrate, the first order mode could propagate if the output electrode width is not less than 2.5$\lambda$.

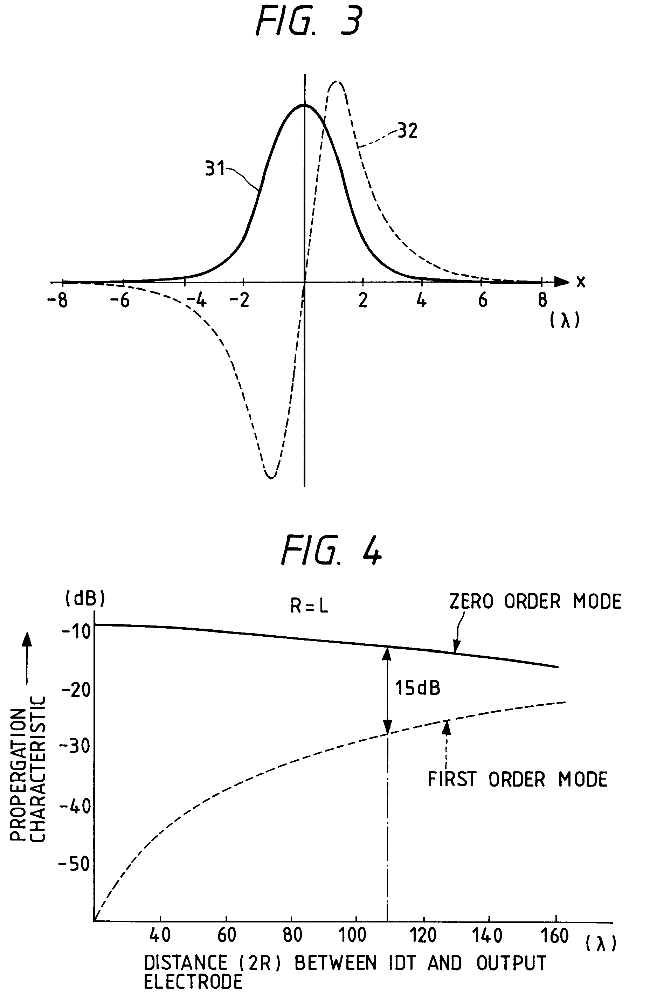

Fig. 3 is an explanatory drawing of the zeroth order mode (fundamental mode) and the first order mode out of the guided modes propagating in the output electrode of width 3$\lambda$.

In the graph shown in Fig. 3, reference numeral 31 represents an amplitude distribution of the zeroth order mode (fundamental mode) for the output electrode width = 3$\lambda$, and 32 an amplitude distribution of the first order mode under the same conditions. The distributions show relative values obtained by such a normalization that the distributions of the zeroth order mode and the first order mode each become 1 when integrated along the X axis.

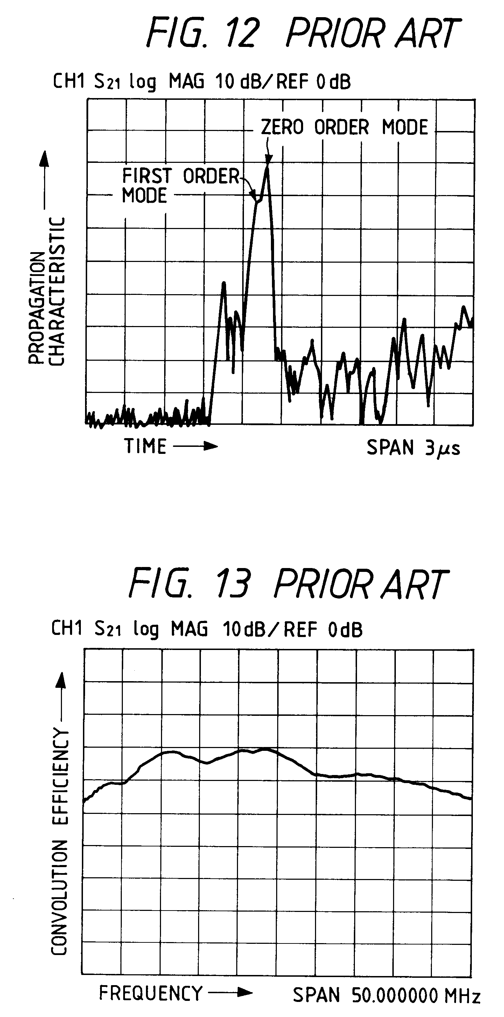

Fig. 11 shows calculation results of a relation of the distance L between the center of curvature O of an arc of IDT and the output electrode against relative values of propagation characteristic at a center frequency of the zeroth order mode or the first order mode, where the output electrode of convolver deviates 0.5° from the direction of the Z axis of crystallographic axis in the YZ-lithium niobate substrate and the IDT has a radius of curvature of R = 80$\lambda$ for the electrode digit of IDT closest to the output electrode. In Fig. 11, the propagation efficiency of the zeroth order mode becomes maximum near L = 80$\lambda$, that is, near 160$\lambda$ between the IDT and the output electrode; but at this point a difference from the propagation efficiency of the first order mode is only about 4 dB.

Fig. 12 shows measurement results of time response of propagation characteristic between input electrodes in the device when the IDT of the radius of curvature R = 80$\lambda$ placed at this point is formed to slightly deviate from the crystallographic axis of substrate. In Fig. 12, the first order mode appears at a little earlier time than the first order mode (fundamental mode).

Fig. 13 shows measurement results of frequency characteristics of convolution output of the device shown in Fig. 12. In the drawing, it is seen that ripple appears in the frequency characteristics to considerably degrade the characteristics of device. Accordingly, the substrate has been required to have high accuracy in orientation flat (hereinafter referred to as "orifla") of substrate and orientation of crystallographic axis, alignment must be precise between the orifla and an orifla mark of mask in fabricating devices, and the direction of the output electrode of convolver needed to match to the Z axis of substrate, which increased the cost of substrate and lowered the yield of devices.

In the above reference 2, the IDT is located in the very proximity of the output electrode by providing the input electrode with frequency dispersion for the purposes of impedance matching and securing the frequency band. The crossing width of electrode digits composing the IDT and disposed in the very proximity of the output electrode needs be approximately equal to the width of output electrode, thus becoming considerably narrow. This increases diffraction, and particularly, if the size of IDT is not more than $5\lambda$, diffraction raises a problem that when the surface acoustic wave is generated by the arcuate IDT, the surface acoustic wave does not converge, but diverges.

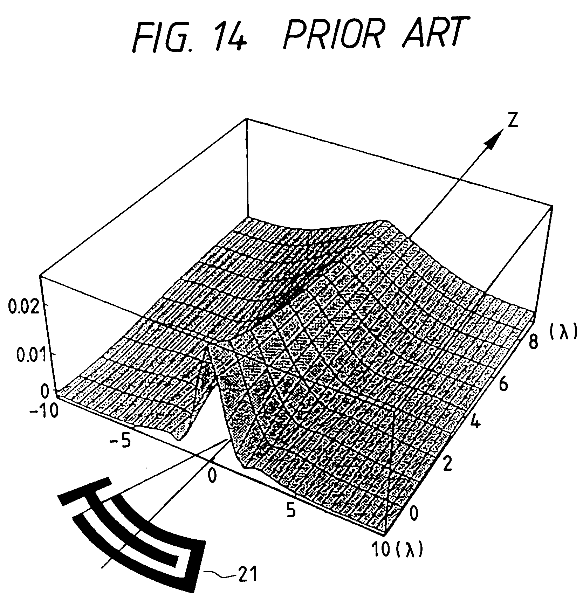

Fig. 14 is a three-dimensional graph to show calculation results, using the Huygens principle, of an amplitude intensity distribution of a surface acoustic wave generated by the arcuate IDT of radius $3\lambda$. As seen from Fig. 14, beyond some $\lambda$ from IDT, the surface acoustic wave spreads quickly; thus, in case of IDT having different places for generating SAWs depending upon the frequency bands, such as dispersive IDT, diffraction losses increase for surface acoustic waves generated by some electrode digits in IDT apart from the output electrode, causing a problem of a decrease in efficiency.

Further, in order to form the IDT as approximately matching to the bending shape of wavefront when the surface acoustic wave propagating in the output electrode is radiated from the end of output electrode and is propagating or in order to design the IDT curved in the shape matching with the velocity anisotropy of piezoelectric substrate as in the above reference 3, designing was impossible unless the velocity anisotropy of substrate was accurately known; but measurement of the velocity anisotropy was difficult and involved large errors, so that accurate designing of IDT was impossible.

## SUMMARY OF THE INVENTION

Objects of the present invention are to achieve the following, solving the above problems:

- To decrease the distance between the input electrode and the output electrode, thereby reducing the device size.
- To provide devices not necessitating high-accuracy in alignment between the Z axis of substrate and the direction of output electrode of convolver, being easy to fabricate, not increasing the cost of substrate, and produced in good yield of devices.
- To provide devices decreased in diffraction loss of surface acoustic wave generated, thereby improving the efficiency.
- To facilitate designing of IDT curved in a shape matching to the velocity anisotropy of piezoelectric substrate.

To achieve the above objects, the present invention provides the following surface acoustic wave apparatus and communication system.

One aspect of the invention provides a surface acoustic wave apparatus which comprises:

a substrate having piezoelectricity;
an input transducer formed on a principal surface of the substrate, for generating a surface acoustic wave;
a waveguide for guiding the surface acoustic wave generated by the input transducer; and
means for converging and inputting the surface acoustic wave generated by the input transducer into said waveguide,

wherein a distance between the means for converging and inputting and an end portion of the waveguide as opposed to the input transducer is in the range of approximately $10\lambda$ and $110\lambda$ both inclusive where $\lambda$ is a wavelength of the surface acoustic wave generated by the input transducer.

Another aspect of the invention provides a communication system for transferring a spread-spectrum-modulated signal, which comprises:

a transmitter for transmitting a spread-spectrum-modulated signal; and
a receiver having a surface acoustic wave apparatus for obtaining a convolution signal between a spread-spectrum-modulated signal input thereinto and a reference signal;

wherein the surface acoustic wave apparatus comprises:

a substrate having piezoelectricity;
an input transducer formed on a principal surface of the substrate, for generating a surface acoustic wave;
a waveguide for guiding the surface acoustic wave generated by the input transducer; and

means for converging and inputting the surface acoustic wave generated by the input transducer into said waveguide;

wherein two said input transducers are opposed to each other on either side of the waveguide, the spread-spectrum-modulated signal being input into one input transducer while the reference signal being input into the other input transducer, and

wherein a distance between the means for converging and inputting and an end portion of the waveguide as opposed to the input transducer is in the range of approximately $10\lambda$ and $110\lambda$ both inclusive where $\lambda$ is a wavelength of the surface acoustic wave generated by the input transducer.

By the structure of the present invention, generation of the first mode can be suppressed on the waveguide without a need to precisely perform alignment of orientation of substrate, which can lower the cost of substrate and can improve the yield.

Also, designing freedom is thus increased for the width of waveguide.

Further, the structure can suppress the decrease in efficiency due to diffraction loss in IDT.

In addition, a high convolution efficiency can be achieved by a simple, arcuate IDT without a need to know accurate velocity anisotropy of substrate.

## BRIEF DESCRIPTION OF THE DRAWINGS

Fig. 1 is a plan view of an embodiment of the present invention;

Fig. 2 is an enlarged drawing of an input, arcuate IDT and an input portion of an output electrode in the embodiment of Fig. 1;

Fig. 3 is an explanatory drawing of the zeroth order mode (fundamental mode) and the first order mode out of guided modes propagating in the output electrode of width $3\lambda$;

Fig. 4 is a drawing to show relative values of propagation characteristic of the zeroth order mode and the first order mode against the distance between IDT and output electrode ( $R + L = 2R$ ) where the radius of curvature R of the arcuate IDT is equal to the distance L from the center of curvature of the arcuate IDT to the output electrode;

Fig. 5 is a drawing to show a relation between the number of pairs in the arcuate IDT and the relative value of convolution efficiency;

Fig. 6 is a drawing to show a relation between the number of pairs and the frequency band;

Fig. 7 is a drawing to show relative values of propagation characteristic of the zeroth order mode and the first order mode against the distance L for IDT of $R = 30\lambda$;

Fig. 8 is a graph to show the time response of propagation characteristic in the embodiment of the present invention;

Fig. 9 is a drawing to show the frequency characteristics of the convolution efficiency in the embodiment of the present invention;

Fig. 10 is a drawing to show relations between the output electrode width and phase velocity of SAW propagating therein with parameters of the respective modes;

Fig. 11 is a drawing to show relative values of propagation characteristic of the zeroth order mode and the first order mode against the distance L for a conventional convolver ($R = 80\lambda$);

Fig. 12 is a drawing to show the time response of propagation characteristic of the conventional convolver;

Fig. 13 is a drawing to show the frequency characteristics of the convolution efficiency in the conventional example of Fig. 12;

Fig. 14 is a three-dimensional graph to show calculation results, using the Huygens principle, of an amplitude intensity distribution of surface acoustic wave generated in an electrode of radius $3\lambda$;

Fig. 15 is a block diagram to show an example of a communication system using the surface acoustic wave device of the present invention;

Fig. 16 is a block diagram to show an example of transmitter and receiver in a communication system using the surface acoustic wave device of the present invention;

Fig. 17 is a block diagram to show an example of transmitter and receiver in a communication system using the surface acoustic wave device of the present invention; and

Figs. 18A and 18B are drawings to show relations between the radius of curvature and the impedance for an arcuate IDT with the center angle of 28° and twelve pairs of digits (where the center frequency is 160 MHz).

## DESCRIPTION OF THE PREFERRED EMBODIMENTS

### Embodiment 1

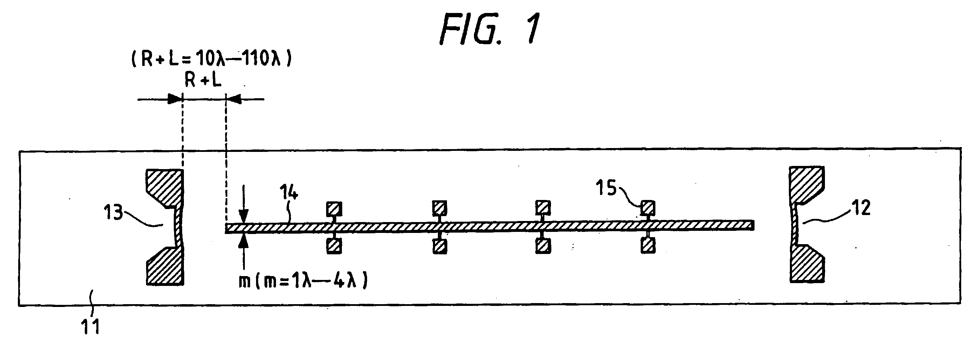

Fig. 1 is a drawing to show a convolver (surface acoustic wave apparatus) as an embodiment of the present invention. In Fig. 1, reference numeral 11 designates a Y-cut (Z-propagate) lithium niobate substrate (hereinafter referred to as a YZ-lithium niobate substrate), 12, 13 input transducers each of an arcuate input interdigital transducer (hereinafter referred to as arcuate IDT), and 14 an output electrode functioning as a waveguide. Further, 15 denotes bonding pads of output terminals.

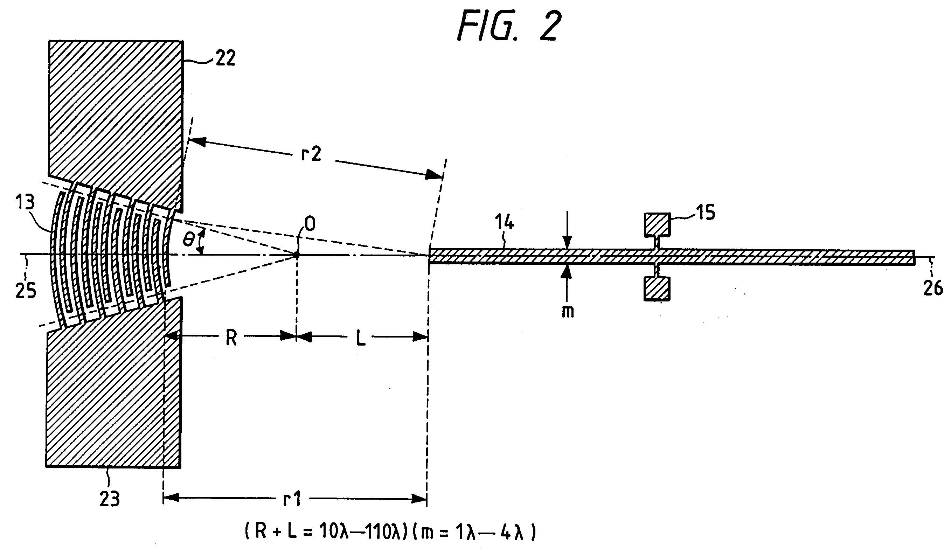

Fig. 2 is an enlarged drawing of a part of the convolver of the present invention shown in Fig. 1, in which 25 - 26 represents the center line of device. In Fig. 2, 13 is the IDT and 14 is the output electrode. The IDT of 13 is of an arcuate shape which is concave to the output electrode in order to concentrate the energy in the output electrode. Further, 2θ is a center angle of the arcuate IDT 13, R is a radius of curvature of the electrode digit of arcuate IDT closest to the output electrode, and L a distance between the input end of the output electrode and the center of curvature O of the arcuate IDT.

Because of the velocity characteristics of YZ-lithium niobate as described above, the SAW generated by the arcuate IDT 13 does not concentrate at the center of curvature O of the arcuate IDT, but concentrates to have a peak at the position L apart from the center of curvature O. Thus, the arcuate IDT is normally located at a position (R + L) apart from the end of output electrode.

When the arcuate IDT is produced of YZ-lithium niobate, L ≈ R in the range of R = 20λ to 85λ (where λ is the wavelength of SAW in the Z-axis direction), which simplifies calculation, and thus, the present embodiment employs this condition.

Fig. 4 is a drawing to show relative values of propagation characteristic of the zeroth order mode and the first order mode against the distance between IDT and output electrode ($R + L = 2R$), where the radius of curvature R of the arcuate IDT is equal to the distance L from the center of curvature of the IDT to the output electrode.

Fig. 4 shows calculation results of a relation of relative values of propagation characteristic at the center frequency of the zeroth order mode or the first order mode against the distance between the arcuate IDT and the output electrode ($R + L = 2R$) for the YZ-lithium niobate substrate, where the direction of the output electrode of convolver deviates 0.5° from the direction of the Z axis and under the condition of $R = L$. Since the maximum deviation between the Z-axis direction of lithium niobate substrate and the direction of output electrode of convolver is within 0.5° in fabrication of convolvers and since ripple can be suppressed to the degree not to cause any problem in practical applications if the difference between the zeroth order mode and the first order mode is at least 15 dB, the distance between the IDT and the output electrode needs to be determined so as to be not more than 110λ.

Incidentally, a SAW generated at the center portion of the arcuate IDT and propagating to the center of the end portion of output electrode and a SAW generated at a portion of a crossing end of electrode digits in the arcuate IDT and propagating to the center of the end portion of output electrode propagate through respective paths r1 and r2 in Fig. 2. Thus, wave numbers k1, k2 of the SAWs are expressed by the following formulas.

$$k1 = r1/\lambda \qquad (1)$$

$$k2 = r2/\lambda 2 \qquad (2)$$

In the above formulas,

$$r1 = R + L \qquad (3)$$

$$r2 = \sqrt{(L + R\cos\theta)^2 + (R\sin\theta)^2} \qquad (4)$$

$$\lambda = v1/f \qquad (5)$$

$$\lambda 2 = v2/f \qquad (6)$$

In this case, λ, λ2, v1, v2 are wavelengths and sound velocities of the SAWs propagating in the respective directions, and f is the frequency of the SAWs. With $R = L$ and $\theta = 15°$, v1 ≈ 3488 m/s and v2 ≈ 3450 m/s. Letting the frequency of the SAWs be 160 MHz and substituting these values into the above formulas, a difference Δ between the wave numbers, k2 - k1, is given by the following Formula (7).

$$\Delta k = 217.6R \qquad (7)$$

When the distance 2R between the IDT and the output electrode is not more than 110λ, the maximum difference Δk between the wave numbers is about 0.25. A phase difference is about 90° due to the difference between the wave numbers, which caused a difference of convolution efficiency being at most about 1 dB between a convolver using the arcuate IDT and a convolver using an electrode compensated for such phase deviation in IDT, i.e., an IDT designed taking account of sound velocities at respective angles. Thus, it is seen that the simple arc shape is sufficient for IDT. It is, however, noted that the present invention can also be applied to IDTs compensated for the phase deviation. In that case, R may be a radius R of a virtual arcuate shape before compensation of phase deviation.

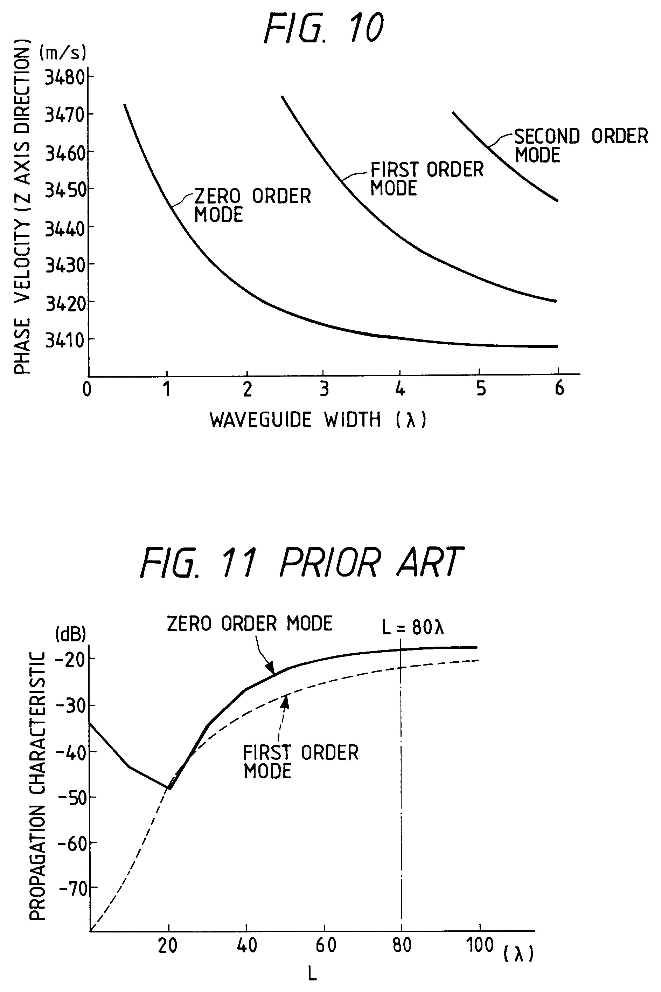

Fig. 10 is a drawing to show relations between the output electrode width (where the electrode width is a length of the electrode in the direction perpendicular to the propagating direction of SAW, and specifically, a length of electrode in the X-axis direction for the YZ-lithium niobate substrate) and the phase velocity of SAW propagating therein with parameters of the respective modes. The way of obtaining the phase velocity shown in this figure is described in detail in "R. V. Schmidt & L. A. Coldren, IEEE Transaction on sonics and ultrasonics, Vol. su-22, March 1975, p115-" (reference 4), and thus only results are shown.

Since the surface acoustic wave apparatus of the present invention is so arranged that the distance between the IDT and the output electrode is set within the range not to generate the first order mode, the upper limit of the width of output electrode is determined by a condition to surely prevent the second order mode from being generated. Specifically, the condition is that the width is not more than 4λ from the drawing.

On the other hand, if the output electrode width is narrow, for example below 1λ, a change of phase velocity becomes particularly large against a change of output electrode width for the zeroth order mode. This means that when SAWs having a wide frequency band propagate in an output electrode operating as a waveguide, a difference becomes large between propagation velocities of the upper and lower SAWs in the frequency band. Thus, in order to obtain a good convolution output with small difference of propagation time against frequency, the output electrode width should be preferably determined not to be smaller than 1λ.

From the above, the surface acoustic wave apparatus of the present invention preferably has the output electrode width in the range of approximately 1λ to 4λ both inclusive.

On the other hand, as the arcuate IDT approaches the output electrode, the radius of curvature of IDT needs be set smaller. Thus, the number of electrode digits in IDT (the number of pairs) needs to be increased for impedance matching. Also, the number of pairs in IDT has a close relation to the convolution efficiency, and thus, the number of digits in IDT is also determined from this relation.

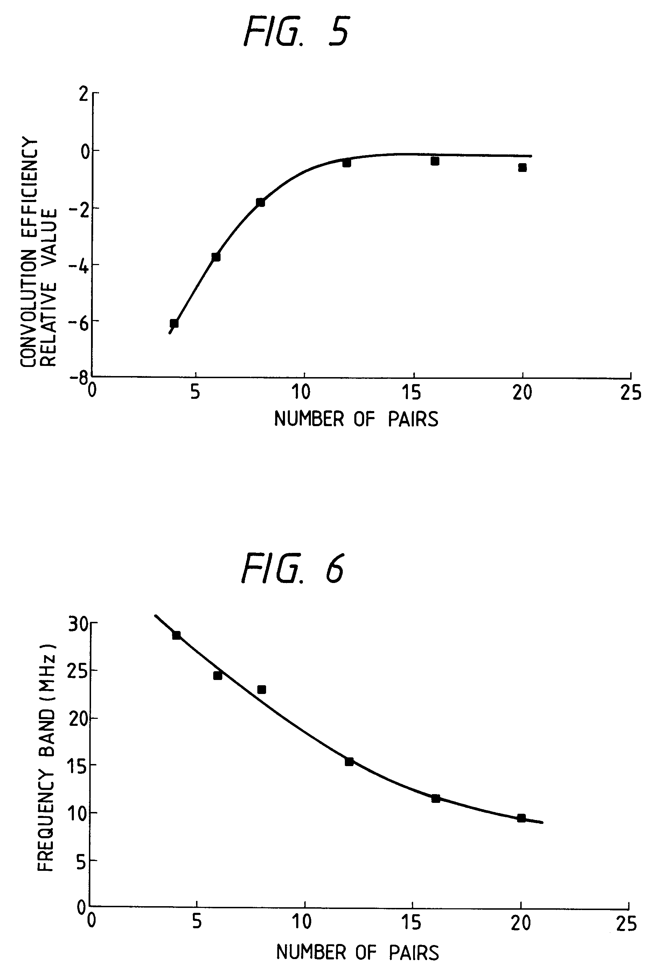

Fig. 5 shows experiment results to show a relation between the number of pairs in IDT and the relative value of convolution efficiency. As shown in Fig. 5, the number of pairs in IDT is preferably at least six pairs in order to obtain a high-efficiency convolver.

The number of pairs in IDT and the input band of IDT (or output band of convolver) are in inverse proportion to each other as shown in Fig. 6, in which the convolution efficiency has little change in the range of over twelve pairs while the band becomes narrower.

Therefore, the number of pairs in IDT is preferably in the range of six pairs to twelve pairs both inclusive for the surface acoustic wave apparatus of the present invention.

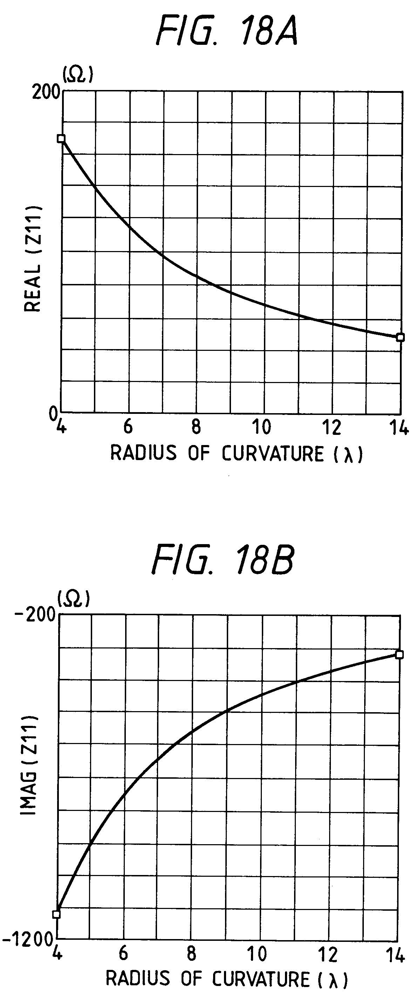

Figs. 18A and 18B show relations between the radius of curvature and the impedance for arcuate IDT with center angle of 28° and twelve pairs of digits (where the center frequency is 160 MHz). Fig. 18A shows the real part of impedance, while Fig. 18B the imaginary part thereof. In Fig. 18A, the real component of impedance becomes beyond 100 Ω if the radius of curvature of arcuate IDT becomes not more than about 7λ (where the distance between the IDT and the output electrode is approximately 10λ); in that case, it is not easy to keep the impedance at 50 Ω, which is the standard for normal high-frequency devices.

The above conditions determine the radius of curvature of arcuate IDT effective to impedance matching and not narrowing the band, and the distance between the IDT and output electrode is at least 10λ.

Accordingly, with the above-described upper value being not more than 110λ, the distance between the IDT and the output electrode in the surface acoustic wave device of the present invention is preferably in the range of approximately 10λ to 110λ both inclusive.

In this case, because the size of IDT is fully larger than the wavelength of SAW and because the IDT is not frequency-dispersive, the entire IDT is excited at all frequencies of IDT, thereby reducing losses due to diffraction.

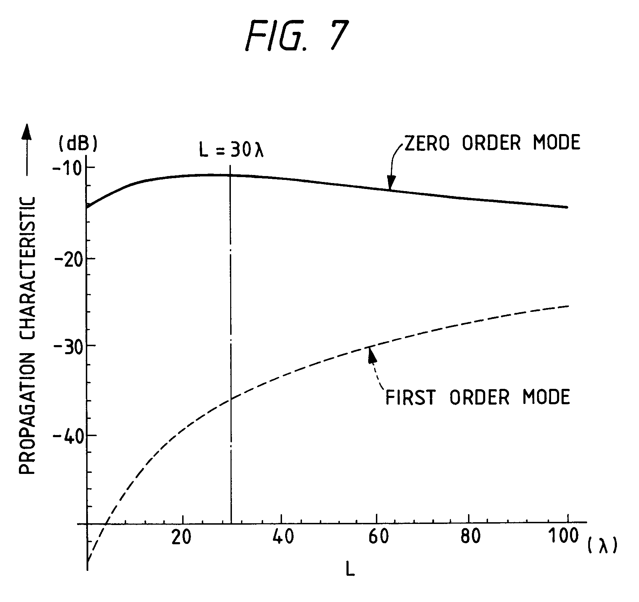

Fig. 7 shows an example of calculation results of relations of relative values of propagation characteristic of the zeroth order mode and the first order mode against the distance between the center of curvature O of arcuate IDT and the output electrode for IDT of $R = 30\lambda$ in the convolver of the present invention, where the output electrode of convolver deviates 0.5° from the direction of the Z-axis of crystallographic axis in the YZ-lithium niobate substrate. As compared with the propagation characteristic of the conventional convolver (Fig. 11; the convolver of $R = 80\lambda$), a difference of propagation intensity between the zeroth order mode and the first order mode is larger, and the first order mode is about 25 dB smaller than the zeroth order mode near at $L = 30\lambda$ where the strongest zeroth order mode propagates.

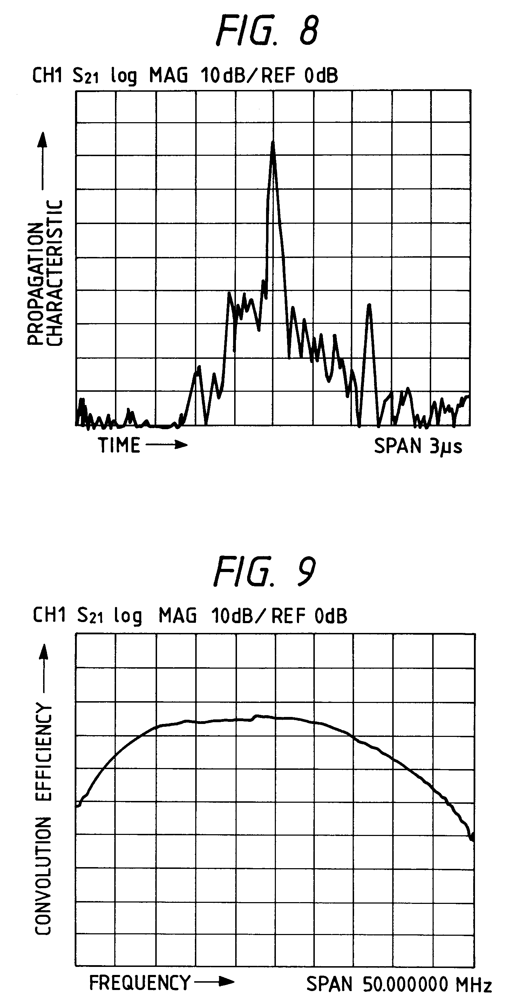

Fig. 8 shows measurement results of time response of the propagation characteristic with the convolver of the present invention. No first order mode is observed, different from the characteristic of time response with the conventional example of Fig. 12.

With such a small first order mode, ripple, as in the conventional example of Fig. 13, is not observed, as shown in the measurement results of frequency characteristics of convolution in Fig. 9, thereby obtaining smooth frequency characteristics.

In the present embodiment, the description was focused mainly on such a convolver of YZ-lithium niobate as to have an arcuate electrode with radius of curvature R and to have the distance L between the center of curvature O and the output electrode being equal to R, but it is noted that the condition of $R = L$ is not intended to limit the present invention.

The present invention was described with the example using YZ-lithium niobate in the present embodiment, but another cut or propagation direction may be employed, and any material other than that may be used as long as it is a substrate indicating anisotropy in velocity of SAW.

The above embodiment showed the example using the monolithic piezoelectric substrate as a substrate, but the substrate may be one having a layered structure in which a piezoelectric thin film is formed on a non-piezoelectric substrate.

The above embodiment showed the example in which the crossing width of electrode digits in the arcuate IDT was arranged with equal center angles, but another structure may be employed, for example structures with different cross widths, such as the apodized structure, or structures with equal cross widths.

The above embodiment showed the example of elastic convolver, but the convolver may be of another type using another nonlinear effect, such as of the AE type.

In the present invention, the IDT may be constructed as a double electrode, whereby reflections at the electrode can be suppressed.

Further, the IDT of the present invention can employ a so-called, unidirectional, interdigital electrode, to which an electric signal, for example, of three or more phases is input and in which the surface acoustic wave is generated only in one direction.

## Embodiment 2

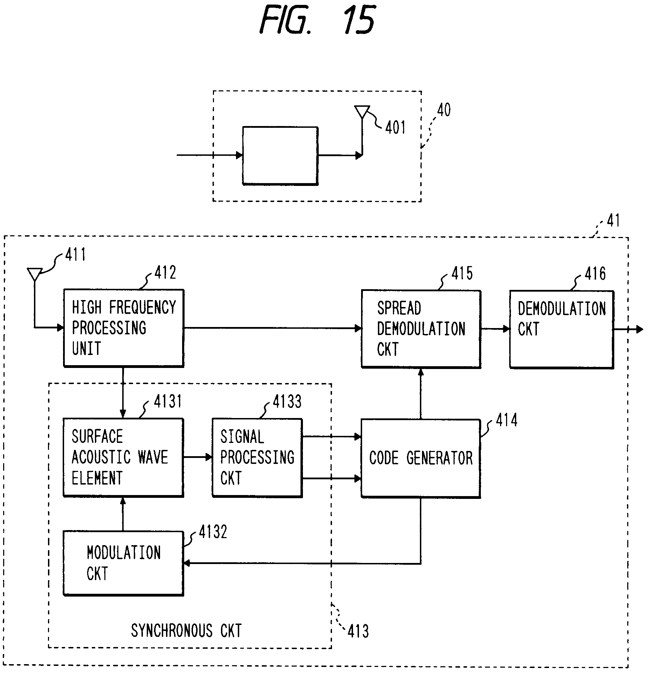

Fig. 15 is a block diagram to show an example of communication system using the surface acoustic wave device as described above.

In Fig. 15, reference numeral 40 designates a transmitter. This transmitter spread-spectrum-modulates a signal to be transmitted using a spread code, and transmits the modulated signal through an antenna 401. The signal transmitted is received and demodulated by a receiver 41. The receiver 41 is composed of an antenna 411, a high-frequency signal processing unit 412, a synchronous circuit 413, a code generator 414, a spread demodulation circuit 415, and a demodulation circuit 416.

A reception signal received through the antenna 411 is properly filtered and amplified in the high-frequency signal processing unit 412, and is output as a transmission frequency band signal as it was or as an appropriate, intermediate frequency band signal after converted. The signal is input into the synchronous circuit 413.

The synchronous circuit 413 is composed of the surface acoustic wave apparatus 4131 as described in the embodiment of the present invention, a modulation circuit 4132 for modulating a reference spread code input thereinto from the code generator 414, and a signal processing circuit 4133 for processing a signal output from the surface acoustic wave apparatus 4131 and outputting a spread code synchronizing signal and a clock synchronizing signal for transmission signal to the code generator 414.

Input into the surface acoustic wave device 4131 are an output signal from the high-frequency signal processing unit 412 and an output signal from the modulation circuit 4132, and the SAW device 4131 performs the convolution operation of the two input signals. Here, assuming that the reference spread code input from the code generator 414 to the modulation circuit 4132 is a time-inverted code of the spread code transmitted from the transmitter, the surface acoustic wave device 4131 outputs a correlation peak when the synchronize only spread code component included in the reception signal is coincident with the reference spread code on the waveguide in the surface acoustic wave device 4131. The signal processing circuit 4133 detects the correlation peak from the signal input thereinto from the surface acoustic wave device 4131, calculates a deviation amount of code synchronization from a time between a code start of the reference spread code and the output of correlation peak, and outputs the code synchronizing signal and clock signal to the code generator 414.

After synchronization is established, the code generator 414 generates a spread code coincident in clock and spread code phase with the transmission-side spread code. This spread code is input into the spread demodulation circuit 415, which restores the signal before spread-modulated.

Since the signal output from the spread demodulation circuit 415 is a signal modulated by a generally used modulation method such as the so-called frequency modulation or phase modulation, data demodulation can be made by the demodulation circuit 416 well known by those skilled in the art.

## Embodiment 3

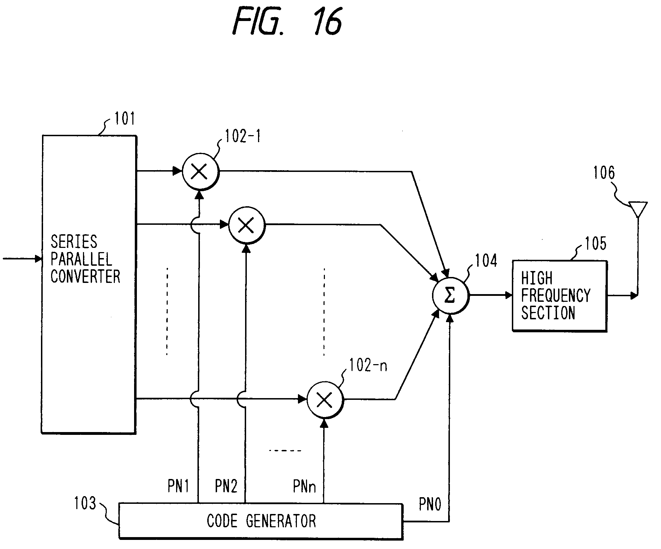

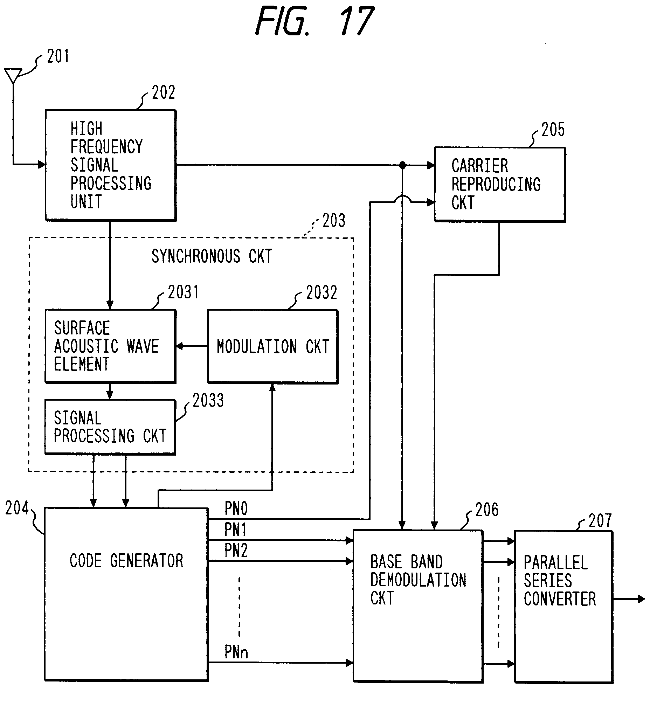

Fig. 16 and Fig. 17 are block diagrams to show an example of transmitter and receiver in a communication system using the surface acoustic wave device as described above.

In Fig. 16, reference numeral 101 designates a series parallel converter for converting serially input data into n parallel data, 102-1 to 102-n multipliers for multiplying the respective parallel data with n spread codes output from a spread code generator, 103 the spread code generator for generating n mutually different spread codes and a synchronize only spread code, 104 an adder for summing the synchronize only spread code output from the spread code generator 103 and n outputs from the multipliers 102-1 to 102-n, 105 a high frequency section for converting an output from the adder 104 into a transmission frequency signal, and 106 a transmission antenna.

In Fig. 17, reference numeral 201 designates a reception antenna, 202 a high-frequency signal processing unit, 203 a synchronous circuit for capturing and maintaining synchronization between the transmission-side spread code and the clock, 204 a spread code generator for generating $(n + 1)$ codes, i.e., spread codes and a reference spread code, same in number as the transmission-side spread codes, from the code synchronizing signal and clock signal input from the synchronous circuit 203, 205 a carrier reproducing circuit for reproducing a carrier signal from a carrier reproducing spread code output from the spread code generator 204 and an output from the high-frequency signal processing unit 202, 206 a base band demodulation circuit for performing demodulation in base band using an output from the carrier reproducing circuit 205, an output from the high-frequency signal processing unit 202, and n spread codes as outputs from the spread code generator 204, and 207 a parallel series converter for parallel-series-converting n parallel demodulation data as outputs from the base band demodulation circuit 206.

In the above structure, on the transmitter side, the series parallel converter 101 first converts data input thereinto into n, which is equal to a code division multiplexing number, parallel data. On the other hand, the spread code generator 103 generates $(n + 1)$ mutually different spread codes $PN_0$ to $PN_n$ with same code period. Among them, $PN_0$ is a code for exclusive use for synchronization and carrier reproduction, which is input directly into the adder 104 without being modulated by the above parallel data. The remaining, n spread codes are modulated by the n parallel data in the multipliers 102-1 to 102-n, and the thus modulated codes are input into the adder 104. The adder 104 linearly sums the (n + 1) signals input thereinto, and outputs a base band signal of the sum to the high-frequency section 105. The base band signal is then converted into a high frequency signal having an appropriate center frequency in the high frequency section 105, and the high frequency signal is transmitted through the transmission antenna 106.

On the receiver side, a signal received through the reception antenna 201 is properly filtered and amplified by the high-frequency signal processing unit 202, and is output as a transmission frequency band signal as it was or as an appropriate, intermediate frequency band signal after converted. The signal is input into the synchronous circuit 203.

The synchronous circuit 203 is composed of the surface acoustic wave apparatus 2031 as described in the embodiment of the present invention, a modulation circuit 2032 for modulating the reference spread code input thereinto from the code generator 204, and a signal processing circuit 2033 for processing a signal output from the surface acoustic wave apparatus 2031 and outputting a spread code synchronizing signal and a clock synchronizing signal for transmission signal to the code generator 204.

Input into the surface acoustic wave device 2031 are an output signal from the high-frequency signal processing unit 202 and an output signal from the modulation circuit 2032, and the SAW device 2031 performs the convolution operation of the two input signals. Here, assuming that the reference spread code input from the code generator 204 to the modulation circuit 2032 is a time-inverted code of the synchronize only spread code transmitted from the transmitter, the surface acoustic wave device 2031 outputs a correlation peak when the synchronize only spread code component included in the reception signal is coincident with the reference spread code on the waveguide in the surface acoustic wave device 2031. The signal processing circuit 2033 detects the correlation peak from the signal input thereinto from the surface acoustic wave device 2031, calculates a deviation amount of code synchronization from a time between a code start of the reference spread code and the output of correlation peak, and outputs the code synchronizing signal and clock signal to the code generator 204.

After synchronization is established, the code generator 204 generates a spread code coincident in clock and spread code phase with the transmission-side spread code. Among these codes, the synchronize only spread code $PN_0$ is input into the carrier reproducing circuit 205.

The carrier reproducing circuit 205 reverse-spreads the reception signal in the transmission frequency band as output from the high-frequency signal processing unit 202 or in the intermediate frequency band after converted, with synchronize only spread code $PN_0$ to reproduce the carrier wave in the transmission frequency band or intermediate frequency band. The structure of the carrier reproducing circuit 205 may be a circuit, for example, utilizing a phase locked loop. The reception signal is multiplied by the synchronize only spread code $PN_0$ in a multiplier.

After synchronization is established, the synchronize only spread code in the reception signal is coincident in clock and code phase with the synchronize only code signal for reference. Since the transmission-side synchronize only spread code is not modulated by data, it is reverse-spread by the multiplier and a component of the carrier wave appears in an output therefrom.

The output is then input into a band pass filter to extract only the carrier wave component, and the carrier wave component is then output. The output is then input into a well-known phase locked loop composed of a phase detector, a loop filter, and a voltage controlled oscillator, and the voltage controlled oscillator outputs a signal locked in the phase of the carrier wave component output from the band pass filter, as a reproduced carrier wave.

The reproduced carrier wave is input into the base band demodulation circuit 206. The base band demodulation circuit produces a base band signal from the thus reproduced carrier wave and an output from the high-frequency signal processing unit 202. The base band signal is distributed to n pieces, and is reverse-spread every code division channel with the spread codes $PN_1$ to $PN_n$ as outputs from the spread code generator 204. Then data demodulation is made. The n parallel demodulation data thus demodulated is converted into serial data in the parallel series converter 207, and the serial data is output therefrom.

The present embodiment showed an example of binary modulation, but orthogonal modulation or another modulation may be employed.

In case that means for converging the surface acoustic wave is provided between the input transducer and the waveguide, the distance between the waveguide-side end of the converging means and the waveguide is to be properly set as described above. It is, however, desired that the input transducer also serve as the converging means, because a separate arrangement of the converging means from the input transducer would increase the device size.

By setting the distance between the input transducer and the waveguide in the proper range, as described above, cheap piezoelectric substrates with normal orifla accuracy can be utilized without using extensive piezoelectric substrates with high orifla accuracy, thus realizing highly cost-competitive convolvers.

Further, high accuracy is not necessary for angular alignment between the crystallographic orientation of the substrate and the direction of the output electrode of convolver in production of devices, thereby enabling to provide convolvers excellent in mass producibility.

Further, there is an advantage that high-efficiency convolvers can be provided in very simple design and of conventional materials by setting the IDT and the number of pairs in the appropriate ranges.

A surface acoustic wave apparatus has a substrate having piezoelectricity, an input transducer formed on a principal surface of the substrate, for generating a surface acoustic wave, a waveguide for guiding the surface acoustic wave generated by the input transducer, and a device for converging and inputting the surface acoustic wave generated by the input transducer into the waveguide. In the apparatus, a distance between the device for converging and inputting and an end portion of the waveguide as opposed to the input transducer is in the range of approximately $10\lambda$ and $110\lambda$ both inclusive where $\lambda$ is a wavelength of the surface acoustic wave generated by the input transducer. A communication system has a transmitter for transmitting a spread-spectrum-modulated signal, and a receiver having the surface acoustic wave apparatus for obtaining a convolution signal between a spread-spectrum-modulated signal input thereinto and a reference signal.

**Claims**

1. A surface acoustic wave apparatus which has:

   a substrate having piezoelectricity;
   an input transducer formed on a principal surface of said substrate, for generating a surface acoustic wave;
   a waveguide for guiding the surface acoustic wave generated by said input transducer; and
   means for converging and inputting the surface acoustic wave generated by said input transducer into said waveguide;

   which is characterized in that a distance between said means for converging and inputting and an end portion of said waveguide as opposed to said input transducer is in the range of approximately $10\lambda$ and $110\lambda$ both inclusive where $\lambda$ is a wavelength of the surface acoustic wave generated by said input transducer.

2. The apparatus according to Claim 1, wherein said input transducer is formed in a concave shape to said waveguide whereby said input transducer also serves as said means for converging and inputting.

3. The apparatus according to Claim 2, wherein said input transducer is an arcuate, interdigital electrode composed of plural pairs of arcuate, interdigital electrode digits concave to said waveguide and approximately concentric with each other, said arcuate, interdigital electrode digits having respective radii of curvature increasing from a waveguide side to a substrate end face side and having a center of curvature on the waveguide side.

4. The apparatus according to either one of Claims 1 to 3, wherein a number of pairs of said interdigital electrode digits is between 6 pairs and 12 pairs both inclusive.

5. The apparatus according to either one of Claims 1 to 4, wherein said substrate having piezoelectricity is made of lithium niobate.

6. The apparatus according to Claim 5, wherein said substrate is a Y-cut plate said first principal plane of which is perpendicular to a Y axis, and a propagation axis of the surface acoustic wave as represented by a longitudinal direction of said waveguide is approximately a Z axis.

7. The apparatus according to either one of Claims 1 to 6, wherein a width of said waveguide is in the range of approximately $1\lambda$ to $4\lambda$ both inclusive.

8. The apparatus according to either one of Claims 1 to 7, wherein two said input transducers are opposed to each other on either side of said waveguide and wherein said waveguide is one that can generate a convolution signal of surface acoustic waves from said two input transducers.

9. The apparatus according to Claim 8, wherein said waveguide also serves as an output electrode for taking out the convolution signal.

10. A communication system for transferring a spread-spectrum-modulated signal, which has:

    a transmitter for transmitting a spread-spectrum-modulated signal; and
    a receiver having a surface acoustic wave apparatus for obtaining a convolution signal between a spread-spectrum-modulated signal input thereinto and a reference signal;

    which is characterized in that said surface acoustic wave apparatus is one as described in either one of Claims 8 and 9.

# FIG. 1

$(R+L=10\lambda-110\lambda)$

R + L

13

14

15

12

m $(m=1\lambda-4\lambda)$

11

FIG. 2

$(R + L = 10\lambda - 110\lambda)\ (m = 1\lambda - 4\lambda)$

# FIG. 3

# FIG. 4

## FIG. 5

## FIG. 6

# FIG. 7

# FIG. 8

CH1 S$_{21}$ log MAG 10dB/REF 0dB

PROPAGATION CHARACTERISTIC

TIME ⟶     SPAN 3µs

# FIG. 9

CH1 S$_{21}$ log MAG 10dB/REF 0dB

CONVOLUTION EFFICIENCY

FREQUENCY ⟶     SPAN 50.000000 MHz

15

## FIG. 10

## FIG. 11 PRIOR ART

# FIG. 12 PRIOR ART

CH1 S21 log MAG 10 dB/REF 0 dB

# FIG. 13 PRIOR ART

CH1 S21 log MAG 10 dB/REF 0 dB

FIG. 14 PRIOR ART

## FIG. 15

SYNCHRONOUS CKT

## FIG. 16

## FIG. 17

## FIG. 18A

## FIG. 18B

European Patent
Office

**EUROPEAN SEARCH REPORT**

Application Number

EP 95 10 7356

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP-A-0 617 510 (CANON KK) 28 September 1994<br>* page 7, line 37 - page 8, line 35 *<br>* page 9, line 7 - page 10, line 21 * | 1,2,5-10 | H03H9/42<br>G10K11/36 |
| A | * figures 2,3,12,14 * | 3,4 | |
| A | IEE PROCEEDINGS G. ELECTRONIC CIRCUITS & SYSTEMS,<br>vol. 137, no. 6 PART G, 1 December 1990<br>pages 467-469, XP 000177137<br>KIRCI M ET AL 'ANALYSIS OF FOCUSED SURFACE WAVE TRANSDUCERS'<br>* page 467, left column, line 21 - right column, line 20 *<br>* page 468, right column, line 13 - line 21 *<br>* figures 1,2 * | 1,2,8 | |
| A | US-A-4 870 376 (WAGERS ROBERT S) 26 September 1989<br>* figure 1 * | 9 | |

TECHNICAL FIELDS
SEARCHED (Int.Cl.6)

H03H
G06G

The present search report has been drawn up for all claims

| Place of search | Date of completion of the search | Examiner |
|---|---|---|
| THE HAGUE | 18 October 1995 | D/L PINTA BALLE.., L |